(19) Europäisches Patentamt / European Patent Office / Office européen des brevets

(11) **EP 1 774 347 B1**

(12) **FASCICULE DE BREVET EUROPEEN**

(45) Date de publication et mention
de la délivrance du brevet:
**11.09.2013   Bulletin 2013/37**

(21) Numéro de dépôt: **05786249.2**

(22) Date de dépôt: **01.07.2005**

(51) Int Cl.:
***G01R 27/16*** *(2006.01)*

(86) Numéro de dépôt international:
**PCT/FR2005/001691**

(87) Numéro de publication internationale:
**WO 2006/013262 (09.02.2006 Gazette 2006/06)**

(54) **PROCEDE DE DETERMINATION DES COMPOSANTES ACTIVE ET REACTIVE DE L'IMPEDANCE DE BOUCLE D'UN RESEAU D'ALIMENTATION EN COURANT ALTERNATIF**

VERFAHREN ZUR BESTIMMUNG VON AKTIVEN UND -REAKTIVEN SCHLEIFENWIDERSTANDSKOMPONENTEN EINES WECHSELSTROMNETZES

METHOD FOR DETERMINING ACTIVE AND REACTIVE LOOP IMPEDANCE COMPONENTS OF AN ALTERNATIVE CURRENT NETWORK

(84) Etats contractants désignés:
**AT BE BG CH CY CZ DE DK EE ES FI FR GB GR HU IE IS IT LI LT LU LV MC NL PL PT RO SE SI SK TR**

(30) Priorité:  **06.07.2004   FR 0407489**

(43) Date de publication de la demande:
**18.04.2007   Bulletin 2007/16**

(73) Titulaire: **Société Chauvin Arnoux
92200 Neuilly sur Seine (FR)**

(72) Inventeurs:
• **ARNOUX Axel**
  **F-75018 Paris (FR)**
• **SIROT Alban**
  **F-75018 Paris (FR)**
• **DELANDE Jean**
  **F-75018 Paris (FR)**

(74) Mandataire: **Thinat, Michel
Cabinet Weinstein
56 A, rue du Faubourg Saint-Honoré
75008 Paris (FR)**

(56) Documents cités:
**EP-A- 0 881 500**

**Description**

L'invention concerne un procédé de mesure de l'impédance de boucle d'un réseau d'alimentation en courant alternatif ainsi qu'un dispositif de mesure pour la mise en oeuvre de ce procédé.

Sur les installations électriques, les normes de sécurité imposent de respecter un certain nombre de critères concernant la sécurité des personnes et des biens.

En particulier, une bonne mise à la terre des châssis métalliques de machines, la présence de dispositifs de protection convenables contre les courts - circuits et contre les défauts d'isolement s'avèrent indispensables. En ce sens, les appareils servant au contrôle des installations électriques doivent permettre, entre autres :

- de vérifier les caractéristiques des circuits de mise à la terre, afin qu'en cas de défaut d'isolement, l'élévation du potentiel de terre n'atteigne pas des valeurs dangereuses,
- d'évaluer quantitativement les caractéristiques du réseau d'alimentation, afin de dimensionner correctement les éléments de protection contre les courts-circuits.

Qu'il s'agisse des caractéristiques des circuits de terre ou de celles du réseau d'alimentation, il est nécessaire de tenir compte de la partie réactive de l'impédance car elle correspond généralement à une part non négligeable (jusqu'à 50%) de l'impédance totale.

En ce qui concerne les circuits de mise à la terre, la mesure de l'impédance de terre s'effectue avec un appareil de mesure dédié (ohmmètre de terre) et de deux piquets additionnels.

Cependant, en zone urbaine, ce genre de mesure s'avère souvent difficile à réaliser car, la plupart du temps, il est impossible de planter des piquets. Dans ce cas, la valeur de l'impédance de boucle « Conducteur de ligne/ Conducteur de protection » peut être prise en compte à la place de l'impédance de terre, pour satisfaire aux règles concernant la protection contre le risque de chocs électriques liés à un défaut d'isolement.

Lorsqu'il est question de mesures d'impédance de boucle, il y a lieu de différencier deux types de mesure bien distincts :

- la mesure d'impédance de boucle du circuit de ligne et de neutre ($Z_{LN}$), impédance appelée « impédance du circuit de ligne » dans la suite du texte
- la mesure d'impédance de boucle du circuit de ligne et de terre ($Z_{LPE}$), impédance appelée « impédance du circuit de terre » dans la suite du texte

La mesure de l'impédance du circuit de ligne permet de déterminer la valeur du courant de court-circuit de l'installation. Connaissant cette valeur, l'installateur pourra dimensionner en conséquence les organes de sécurité (fusibles, disjoncteurs, etc.), ces derniers devant obligatoirement pouvoir supporter ce courant de court-circuit pendant le laps de temps nécessaire à leur déclenchement.

La mesure d'impédance du circuit de terre permet de fixer la sensibilité du disjoncteur différentiel (courant différentiel de fonctionnement assigné), sachant qu'en cas de défaut d'isolement, l'élévation du potentiel de terre ne doit pas atteindre une valeur considérée comme dangereuse pour les personnes.

Jusqu'à présent, la mesure de l'impédance de boucle(s) d'une installation se cantonnait à l'application directe de la loi d'Ohm, c'est-à-dire :

- soit en injectant un courant "I" en régime permanent dans le circuit de boucle, puis en mesurant la différence de potentiels "V" développée aux bornes dudit circuit de boucle et enfin en effectuant le quotient V/I,
- soit en appliquant une différence de potentiels en régime permanent aux bornes du circuit de boucle, puis en mesurant le courant de régime permanent traversant ledit circuit de boucle et enfin en effectuant le quotient V/I.

Ce procédé, relativement simple à mettre en oeuvre, ne fournit cependant que le module de l'impédance de boucle. Or il peut être intéressant de savoir si l'impédance est surtout liée à des résistances parasites (connexions, longueur des conducteurs...) ou à un effet selfique: inductance(s) ramenée(s) par le transformateur de tête, longueur et disposition spatiale des conducteurs d'amenée etc. La connaissance de la composante résistive et de la composante inductive fournit en effet des informations aidant à localiser le ou les éléments en défaut dans l'installation électrique. Par exemple, si l'impédance présente un caractère plutôt inductif, il y a plus de chance que le transformateur d'alimentation en soit la cause...

Par ailleurs, le principe habituellement utilisé sur les appareils du commerce et utilisant un fonctionnement en régime de courant permanent, nécessite une durée de mesure non négligeable (nécessité d'attendre la disparition du régime transitoire). Il ne peut donc s'appliquer qu'à des courants relativement faibles, vu qu'il est physiquement impossible de dissiper une énergie importante dans l'appareil de mesure. En conséquence, le signal mesuré est également de faible amplitude, ce qui ne garantit pas une précision suffisante. Le document EP 0 881 500 A décrit un procédé pour la mesure de l'impédance de boucle d'un réseau d'alimentation en courant avec conducteur neutre.

Le but de l'invention est de remédier aux inconvénients énoncés plus haut.

Le but de l'invention est atteint avec un procédé de détermination des composantes active et réactive de l'impédance de boucle d'un réseau d'alimentation en courant alternatif fournissant le courant sous une tension de réseau, c'est-à-dire la mesure des tensions et courants de boucle, suivi d'un calcul subséquent du module des composantes active et réactive de l'impédance de boucle, la boucle comprenant un conducteur de ligne du réseau et au moins un des deux conducteurs suivants :

■ un conducteur de neutre du réseau,
■ un conducteur de protection par mise à la terre,

procédé selon lequel on applique une charge à la boucle (appelée « charge de test » dans la suite de la présente description), on mesure les tensions de la boucle respectivement avant que la charge de test soit appliquée (mesure « à vide ») et lorsque la charge de test est appliquée (mesure « en charge »), on mesure l'évolution temporelle du courant pendant la durée pendant laquelle la charge de test est appliquée et on détermine les parties active (résistance « R ») et réactive (inductance « L ») de l'impédance de boucle par analyse conjointe d'une part des résultats de mesures différentielles de tension de boucle et d'autre part de l'évolution temporelle du courant dans la charge de test, conformément à la description détaillée ci-après.

Pour le calcul du module des composantes active et réactive de l'impédance de boucle on utilise les formules suivantes :

$$R = \frac{\hat{I}_{t1} \bullet \Delta U_2 - \hat{I}_{t2} \bullet \Delta U_1}{\hat{I}_{t1} \bullet \underline{I}_2 - \hat{I}_{t2} \bullet \underline{I}_1} \qquad\qquad L = \frac{\Delta U_2 \bullet \underline{I}_1 - \Delta U_1 \bullet \underline{I}_2}{\hat{I}_{t2} \bullet \underline{I}_1 - \hat{I}_{t1} \bullet \underline{I}_2}$$

où :

$\hat{I}_n$ représente la valeur instantanée « Ipic1 » du courant dans la charge de test à la fin de la durée « T1 »
$\hat{I}_{t2}$ représente la valeur instantanée « I$_{pic2}$ » du courant dans la charge de test à la fin de la durée « T2 »
$\underline{\Delta U_1}$ représente la valeur intégrale de la différence de tension [« à vide » - « en charge »] pendant la durée « T1 »
$\underline{\Delta U_2}$ représente la valeur intégrale de la différence de tension [« à vide » - « en charge »] pendant la durée « T2 »
$\underline{I_1}$ représente la valeur intégrale du courant dans la charge de test pendant la durée « T1 »
$\underline{I_2}$ représente la valeur intégrale du courant dans la charge de test pendant la durée « T2 »

Conformément à l'invention, la charge de test est appliquée de manière que le courant à mesurer se présente sous la forme d'une impulsion de courant de forte amplitude et de faible largeur, la variation de la tension de boucle est analysée dynamiquement par une mesure différentielle de la tension de boucle avant et pendant application de la charge de test et l'évolution temporelle du courant est analysée pendant application de la charge de test.

Le système selon l'invention consiste donc à appliquer une impulsion de courant de forte amplitude et de faible largeur par application d'une charge de test afin d'analyser dynamiquement l'évolution de la tension de boucle et du courant dans la charge de test.

Avantageusement, cette impulsion est appliquée sur le sommet ou à proximité immédiate du sommet de la tension sinusoïdale. L'avantage d'un tel système est que le courant appliqué est important et donc que le signal à mesurer a un rapport signal / bruit optimal. Par ailleurs, ce principe permet d'extraire, sous forme de deux valeurs distinctes, la partie réelle et la partie réactive de l'impédance, ce qui apporte des informations supplémentaires à l'utilisateur et par là même, un confort d'utilisation.

L'invention concerne par ailleurs également les caractéristiques ci-après, considérées isolément ou selon toutes leurs combinaisons techniquement possibles :

- l'impulsion de courant est obtenue par une commande électronique d'application de la charge de test, cette commande étant déclenchée par l'instrument de mesure effectuant les mesures différentielles de la tension de boucle et les mesures de l'évolution temporelle du courant ;
- la charge de test est appliquée de manière répétée de façon que la mesure de tension et de l'évolution temporelle du courant puissent être effectués, cumulés, moyennés sur plusieurs impulsions ;

- la charge de test est appliquée de manière répétée de façon que le courant puisse être mesuré sous la forme d'au moins deux impulsions par période de la tension de réseau;
- d'une période de la tension de réseau à l'autre, la séquence d'une impulsion avant application de la charge et d'une impulsion pendant application de la charge est inversée ;
- l'impédance est obtenue moyennant une intégration des résultats des mesures respectivement de la tension différentielle de boucle et du courant.

Le but de l'invention est également atteint avec un dispositif de mesure et de détermination d'impédance de boucle pour la mise en oeuvre du procédé décrit plus haut. Ce dispositif comprend un pont diviseur d'entrée destiné à être raccordé à un réseau électrique dans lequel l'impédance de boucle doit être mesuré. Selon le mode de réalisation choisi, il s'agit d'un simple ou d'un double pont diviseur. Le dispositif de mesure comprend en outre, respectivement pour la mesure d'une tension et la mesure d'un courant à partir desquels l'impédance de boucle doit être déterminée, au moins un intégrateur relié au pont diviseur par une mémoire tampon et une commande marche/arrêt ainsi que des moyens de mesure et de traitement recevant des signaux issus du ou des intégrateurs et comprenant des moyens de mise à disposition des résultats de mesure.

D'autres caractéristiques et avantages de l'invention ressortiront de la description détaillée ci-après des procédé et dispositif de mesure, description en référence aux dessins dans lesquels :

- La figure 1 montre le schéma de principe d'un circuit de mesure selon l'invention,
- La figure 2 montre l'évolution typique du courant pendant l'application de la charge de test,
- La figure 3A montre une première possibilité application d'impulsions de courant,
- La figure 3B montre une seconde possibilité application d'impulsions de courant,
- La Figure 4 montre une extension du schéma de la figure 3A pour expliciter le procédé selon l'invention,
- La figure 5 illustre la notion de mini-cycles,
- Les figures 6 et 7 montrent, à titre d'illustration, la chute de tension du réseau lors de l'application d'une impulsion de courant en fonction du type de charge respectivement purement résistive ou à composante inductive,
- La Figure 8 montre l'évolution typique du courant pendant l'application de la charge de test et
- Les figures 9 et 10 montrent des schémas de principe d'un circuit de mesure avec un dispositif de mesure d'impédance de boucle selon l'invention.

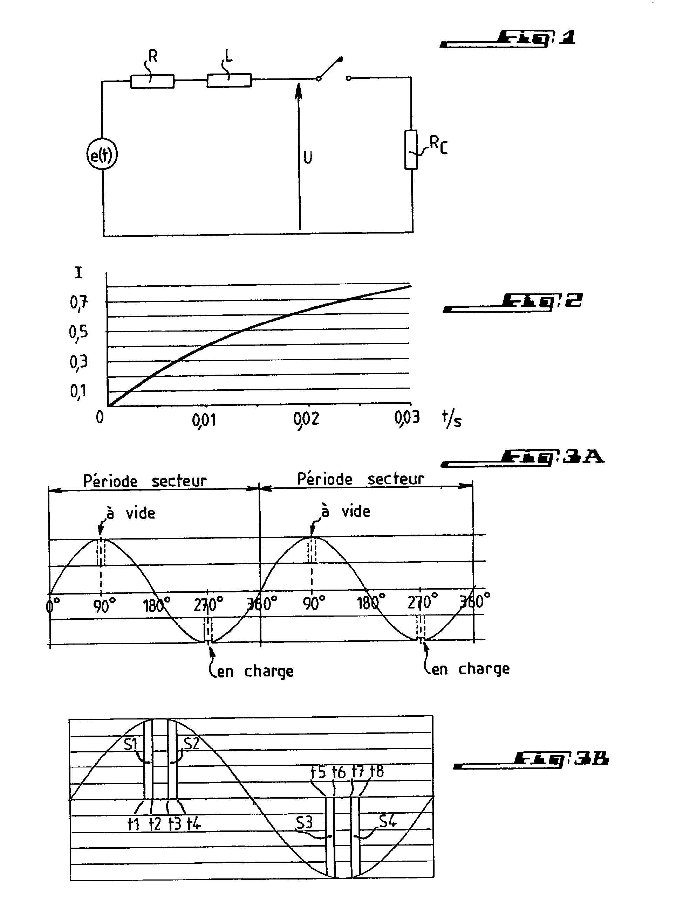

Le principe de mesure est illustré par le schéma représenté sur la figure 1, où :

- e(t) est la tension sinusoïdale fournie par le réseau d'alimentation électrique (secteur),
- R et L symbolisent la résistance et l'inductance du circuit de ligne ou du circuit de terre
- $R_C$ est une charge commandée électroniquement par l'appareil de mesure et qui permet de créer l'impulsion de courant.

La forme de l'impulsion de courant est directement liée à la constante de temps $\tau$ du circuit :

$$\tau \;=\; L \;/\; (R + R_C)$$

La figure 2 illustre l'évolution de ce courant impulsionnel :

Les phénomènes caractérisant la partie résistive et la partie inductive de l'impédance de ligne (ou de terre) sont, d'une part, la variation de tension entre une impulsion "à vide" (courant nul) et une impulsion "en charge" (courant non nul) et d'autre part, l'évolution temporelle du courant pendant l'application de la charge.

La tension délivrée par le secteur a une forme approximativement symétrique (symétrie centrale), comme cela est représenté sur la figure 3A. Cette particularité est mise à profit pour réaliser, analogiquement ou numériquement parlant, la différence "tension à vide" - "tension en charge". En effet, il suffit pour cela de mesurer l'alternance positive "à vide" alors que l'alternance négative est mesurée "en charge". La différence est une simple somme arithmétique des deux mesures, vu que les alternances sont de signes opposés.

Le principe de mesure correspond en fait à une mesure "différentielle" du signal, puisqu'il est nécessaire d'effectuer la différence entre le signal "à vide" et le signal "en charge" ; le résultat de cette différence est lié à la valeur de l'impédance interne de la source. La mesure utilise donc avec profit le fait qu'il y ait une alternance positive puis une alternance négative, pour effectuer cette différence.

Tous les traitements et calculs à effectuer dans le cadre de la mesure puis de la détermination d'impédance de boucle selon l'invention sont menés électroniquement, soit par des intégrateurs, des sommateurs, des soustracteurs, des multiplicateurs analogiques ou numériques câblés, soit par le biais de composants microprogrammés tels que, par exemple, des microprocesseurs, des DSP, des FPGA, des CPLD...

Dans l'un des paragraphes précédents, il a été émis l'hypothèse que les deux alternances du réseau électrique étaient de même forme (symétrie centrale). Ce n'est toutefois pas strictement le cas dans la réalité.

Pour faire disparaître ou du moins atténuer fortement ce défaut de symétrie, il est procédé à une inversion du rôle des alternances à chaque période : par exemple, dans un premier temps, l'alternance positive sert pour l'impulsion « en charge » et l'alternance négative sert pour l'impulsion « à vide ». Puis, dans un deuxième temps, l'alternance positive sert pour l'impulsion « à vide » et l'alternance négative sert pour l'impulsion « en charge ». On parlera alors respectivement de période secteur « paire » et de période secteur « impaire ».

En ce qui concerne l'intégration des signaux, il est donc procédé à deux sommes partielles, menées concurremment : celle correspondant aux périodes paires et celle correspondant aux périodes impaires.

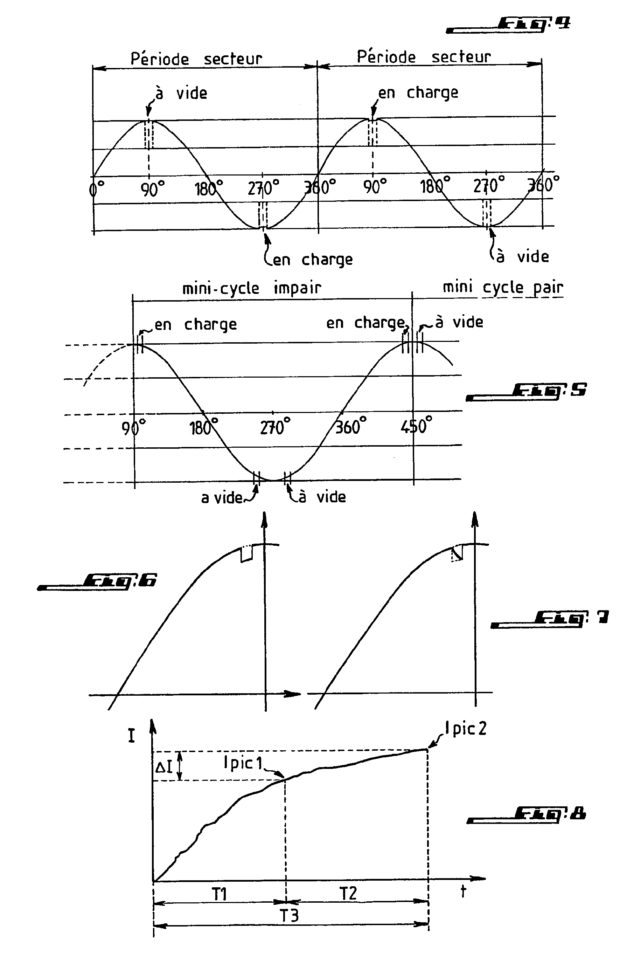

Une fois ces deux sommes effectuées, il est procédé au calcul de la différence de ces deux sommes partielles. La figure 4 explicite le processus de mesure.

Afin de s'affranchir des déformations pouvant survenir sur le sommet de la sinusoïde de tension (écrêtage par charge diode/condensateur ou plus généralement: distorsion par harmonique 3 et/ou de rangs supérieurs), la mesure s'effectue de part et d'autre du sommet. Pour chaque sommet d'alternance, il est donc pratiqué deux impulsions de mesure au lieu d'une seule, ces deux impulsions étant situées de part et d'autre du sommet d'alternance, comme illustré par la figure 5.

Pour réaliser la soustraction des résultats « mesure à vide » - « mesure en charge », les impulsions "à vide" et "en charge" sont systématiquement appliquées sur des alternances opposées. Ainsi, on applique, par exemple, une impulsion « à vide » sur le flanc arrière de l'alternance positive, puis une impulsion « en charge » sur le flanc avant de l'alternance négative, etc. Ce principe est également utilisé pour éviter qu'il y ait deux intégrations consécutives de même signe, par exemple deux intégrations « à vide » qui se suivraient, car ceci pourrait faire passer l'intégrateur en saturation.

Ceci impose de commencer la mesure sur le flanc arrière d'une arche de sinus, d'où la notion de « mini-cycle » (voir figure 5).

Plusieurs mini-cycles seront enchaînés, à concurrence d'un nombre $N_{max}$, afin de limiter la durée globale de mesure si la tension différentielle « impulsion à vide - impulsion en charge » est très faible voire nulle, et à concurrence de l'atteinte d'un seuil par la sortie de chaque intégrateur. Ce seuil est fixé pour avoir la plus grande dynamique possible, mais également pour éviter la saturation de l'intégrateur.

De plus, afin de minimiser l'influence d'éventuelles dissymétries, un moyennage est réalisé à partir des valeurs absolues des résultats de mesure obtenus :

1. en partant depuis une alternance positive, tel qu'illustré par la Figure 5, ce qui fournit un résultat d'intégration globalement négatif, car la valeur « en charge » est plus faible, en valeur absolue, que la valeur « à vide » ;
2. en partant depuis une alternance négative, ce qui fournit un résultat d'intégration globalement positif, car la valeur « à vide » est plus grande, en valeur absolue, que la valeur « en charge ».

Ceci amène à la notion de mini-cycles impairs, qui commencent par une impulsion « en charge », et à celle de mini-cycles pairs, qui commencent par une impulsion « à vide ». Les résultats de ces deux séries de mesures étant de signes contraires, il est également possible d'en obtenir la moyenne en calculant la différence algébrique des résultats.

Ces modes alternés de mesure ont également pour objet de ne pas rendre trop dissymétrique le courant impulsionnel de mesure.

La Figure 5 illustre la notion de mini-cycles pair et impair. Dans cet exemple, l'intégration commence avec une impulsion « en charge » et sur la fin de l'alternance positive. En terme d'intégrale, elle est grossièrement contrebalancée par l'intégration « à vide » sur le flanc avant de l'alternance négative.

En pratique et dans certains cas, la résultante est proche de zéro (mais pas totalement nulle car le réseau électrique présente généralement une impédance interne non négligeable). Si le résultat de l'intégration est faible, il est possible de cumuler plusieurs cycles d'intégrations différentielles (« à vide » - « en charge »), en utilisant le flanc arrière de l'alternance négative pour réaliser une intégration « à vide » puis l'intégration « en charge » sur le flanc avant de l'alternance positive. Il y a donc alors au total deux intégrations « en charge » sur l'alternance positive et deux intégrations « à vide » sur l'alternance négative. Pour un mini-cycle impair, le résultat est donc : deux fois l'intégrale de la différence entre impulsion « en charge » et impulsion « à vide ».

Lorsqu'une impulsion « en charge » est brutalement appliquée sur la tension délivrée par le réseau, il s'en suit une brève chute de tension.

La forme de cette chute de tension dépend de la structure de l'impédance interne de la source.

Si cette impédance interne est purement résistive, la chute de tension a la forme d'un créneau (voir figure 6) ;

Si cette impédance interne possède une composante selfique, cette dernière s'oppose à toute variation brutale du courant. L'évolution temporelle de la chute de tension a alors une forme approximativement exponentielle (voir la figure 7). La forme du courant de charge a également, dans ce dernier cas, une allure exponentielle (voir la courbe figure 8).

Outre l'intégration sur le courant, la détermination de la partie résistive et de la partie selfique de l'impédance du circuit nécessite de connaître les valeurs des intégrales de tension pendant le laps de temps T1 et le laps de temps T2, suivant les notations indiquées sur la figure 8.

Ces opérations sont réalisées au moyen d'intégrateurs analogiques ou par cumul d'échantillons de mesure. Dans ce dernier cas, il s'agit d'une des tâches remplies par le dispositif à logique micro-programmée. Dans une première phase de mesure, l'intégrateur effectue l'intégrale de la tension sur le temps T1 et ce, pendant N mini-cycles consécutifs. La valeur de N est fixée, soit par le fait que la sortie de l'intégrateur atteint un certain seuil prédéterminé (à partir de ce seuil, le cumul intégral est considéré comme suffisant), soit par un "time-out" (cas où le signal est très faible voire nul, auquel cas N = N$_{MAX}$). La valeur en sortie d'intégrateur est alors mémorisée par l'unité de traitement.

Dans une deuxième phase, l'intégrateur est remis à zéro puis effectue l'intégrale de la tension sur le temps T2 pendant N mini-cycles consécutifs, la valeur de N étant fixée de la même manière que celle décrite au paragraphe précédent.

A partir des valeurs de temps, de courant et de tension mesurés et intégrés, les calculs fournis ensemble à la fin de la description montrent comment sont calculées les valeurs de la partie résistive (résistance "R") et de la partie réactive (inductance "L") du circuit à caractériser. Une fois calculées, ces valeurs "R" et "L" sont alors affichées sur l'écran de l'appareil de mesure.

Le fait d'utiliser un seul intégrateur pour la tension est pénalisant en temps. L'utilisation de deux intégrateurs montés en parallèle, l'un pour l'intégration de la tension pendant T1 et l'autre pour l'intégration de la tension pendant T2, permet de diviser par deux le temps de mesure. L'impact est très significatif en terme d'échauffement interne dans l'appareil.

En conclusion et pendant les impulsions, qu'elles soient de types "à vide" ou "en charge", la chaîne de mesure et de traitement effectue simultanément les opérations suivantes :

1. Intégration de la tension pendant le temps T1 (rôle de l'intégrateur n° 1)
2. Intégration de la tension pendant le temps T2 (rôle de l'intégrateur n°2)
3. Intégration du courant pendant le temps T3 = T1+T2 (rôle de l'intégrateur n°3)

Dans un dispositif de mesure destiné à mettre en oeuvre le procédé de mesure selon l'invention, les intégrateurs n° 1 et n° 2 sont réalisés par le biais d'amplificateurs opérationnels (montage intégrateur classique), alors que l'intégration du courant (intégrateur n° 3) est réalisée numériquement : cumul des échantillons de mesure obtenus par conversion Analogique/Numérique. Cependant, il est tout à fait possible d'utiliser indifféremment des intégrateurs numériques ou analogiques pour la réalisation de ces trois intégrations de signaux.

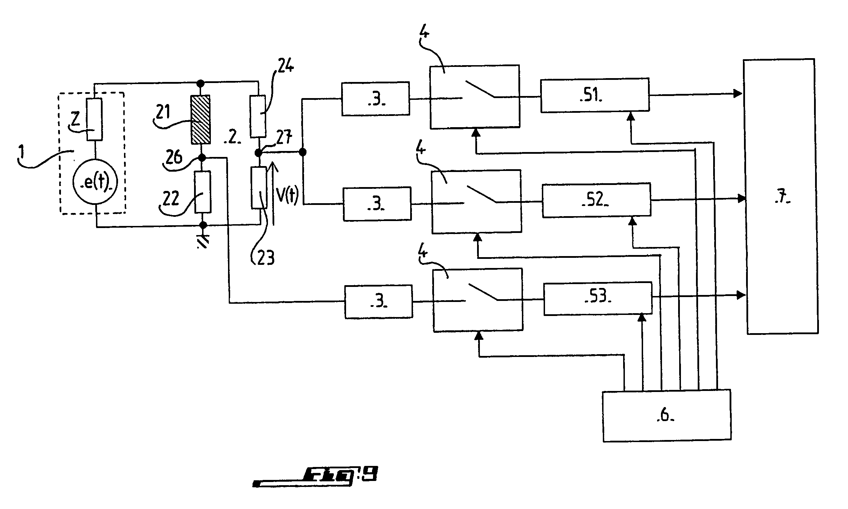

La figure 9 n'est pas à proprement parler le schéma exact d'un tel dispositif de mesurage, mais elle fournit une aide à la compréhension du principe de mesure selon l'invention.

Le dispositif de mesure comprend donc un double pont diviseur d'entrée 2 destiné à être raccordé à un réseau électrique 1 dans lequel l'impédance de boucle doit être mesurée. Ce double pont diviseur d'entrée 2 comporte les quatre résistances habituelles 21 à 24, la résistance 21 constituant une charge commandée et la résistance 22 une résistance shunt de mesure. Le noeud d'interconnexion entre les résistances 21 et 22, référencé 26, sert à la mesure de l'évolution du courant pendant l'intervalle de temps T3, alors que le noeud d'interconnexion entre les deux autres résistances 23, 24, référencé 27, sert à la mesure de la tension respectivement pendant les intervalles de temps T1 et T2.

Les impulsions venant du noeud d'interconnexion 27 sont amenées, à travers deux étages séparateurs 3 et deux commandes marche/arrêt 4 dédiées à l'intégration de tension respectivement pendant le temps T1 et pendant le temps T2, vers les intégrateurs 51 et 52. De manière analogue, les impulsions venant du noeud d'interconnexion 26 sont amenées, à travers l'étage séparateur 3 et la commande marche/arrêt 4 dédiées à l'intégration du courant pendant le temps T3, vers l'intégrateur 53. Le fonctionnement des commandes 4 et des intégrateurs 51 à 53 est commandé par une logique de séquencement 6. Les résultats des intégrations effectuées par les intégrateurs 51 à 53 sont envoyés à des moyens de mesure et de traitement 7, qui comprennent des moyens de mise à disposition des résultats de mesure.

Dans la pratique, les mesures "intégrales" de tension doivent s'effectuer de manière différentielle car le pied du pont diviseur de tension n'est pas au potentiel de la masse "mesure". En effet, des composants électroniques de protection doivent être impérativement insérés entre la masse "mesure" et ce pied de pont.

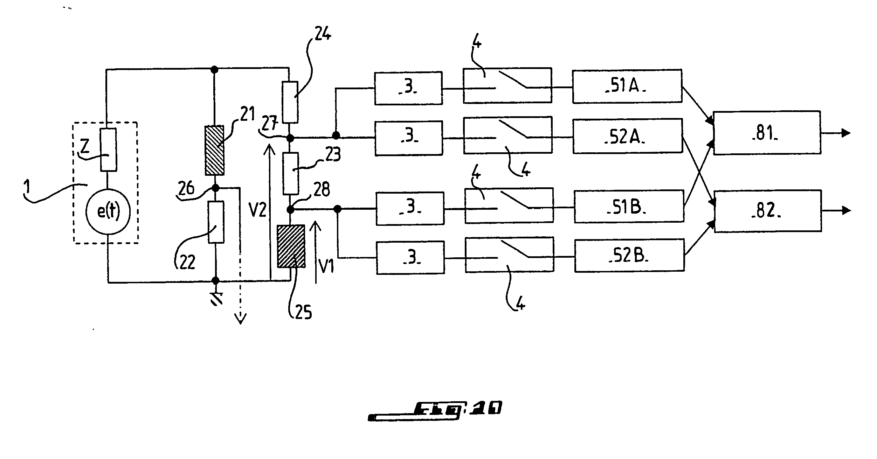

Il est donc nécessaire de doubler le nombre d'intégrateurs pour la mesure de la tension. La figure 10 montre qu'il y a en effet deux paires d'intégrateurs, référencés respectivement 51A, 52A, 51B, 52B, ce qui implique de pourvoir le dispositif également d'un nombre double d'étages séparateurs et de commandes marche/arrêt. Les sorties des intégrateurs sont reliées à des soustracteurs 81, 82. La sortie de chaque soustracteur fournit donc l'intégrale de la tension différentielle présente aux bornes de la résistance 23.

La figure 10 montre par ailleurs la mise en place, dans le pont diviseur d'entrée 2, d'un composant de protection disposé en série avec les résistances 23, 24 et donnant naissance à un noeud d'interconnexion supplémentaire 28.

**Les calculs théoriques sur lesquels le procédé de l'invention est fondé sont les suivants.**

La fonction e(t) est supposée isochrone. L'équation de la tension aux bornes de la charge « $R_C$ » est la suivante, référence étant faite à la figure 1:

$$U_{Rc} = e(t) - R \bullet i(t) - L \bullet \frac{di}{dt} \qquad \text{[EQ1]}$$

Le courant $i_1$ et l'indice « Rc1 » correspondant à la mesure à vide, alors que le courant $i_2$ et l'indice « $_{Rc2}$ » correspondant à la mesure en charge, on a alors:

$$\Delta U_{Rc} = U_{Rc2} - U_{Rc1} = R \bullet \left(i_2(t) - i_1(t)\right) + L \bullet \left(\frac{di_2}{dt} - \frac{di_1}{dt}\right) \qquad \text{[EQ5]}$$

En posant $\Delta i(t) = i_2(t) - i_1(t)$, il en resulte que :

$$\Delta U_{Rc} = R \bullet \left(i_2(t) - i_1(t)\right) + L \bullet \left(\frac{di_2}{dt} - \frac{di_1}{dt}\right) = R \bullet \Delta i(t) + L \bullet \frac{d(\Delta i)}{dt}$$

$$\text{[EQ6]} \quad \text{et} \quad \text{[EQ7]}$$

En utilisant [EQ5] et en intégrant membre à membre entre les instants $t_a$ et $t_b$, on obtient :

$$\int_{ta}^{tb} \left(U_{Rc2}(t) - U_{Rc1}(t)\right)dt = R \bullet \int_{ta}^{tb} \left(i_2(t) - i_1(t)\right)dt + L \bullet \int_{ta}^{tb}\left(\frac{di_2}{dt} - \frac{di_1}{dt}\right)dt \quad \text{[EQ9]}$$

ce qui donne:

$$\int_{ta}^{tb} \left(U_{Rc2}(t) - U_{Rc1}(t)\right)dt = R \bullet \int_{ta}^{tb} \left(i_2(t) - i_1(t)\right)dt + L \bullet \left([i_2(t)]_{ta}^{tb} - [i_1(t)]_{ta}^{tb}\right) \quad \text{[EQ10]}$$

Avec : $i_2(t) = \dfrac{U_{Rc2}(t)}{Rc2}$ et $i_1(t) = \dfrac{U_{Rc1}(t)}{Rc1}$ [EQ11a] et [EQ11b]

Dans le cas de notre mesure, « Rc » est, d'une manière très générale, la résistance de charge appliquée par notre appareil de mesure. « Rc2 » est la résistance de charge, dont la valeur va faire réagir le réseau électrique sur lequel elle est connectée. En revanche « Rc1 » est la résistance en circuit ouvert ; le courant $i_1(t)$ est donc nul ; on peut alors simplifer l'équation [EQ10] qui s'écrit maintenant comme suit:

$$\int_{ta}^{tb}\left(U_{Rc2}(t) - U_{Rc1}(t)\right)dt = R \bullet \int_{ta}^{tb} i_2(t)dt + L \bullet [i_2(t)]_{ta}^{tb} = R \bullet \int_{ta}^{tb} i_2(t)dt + L \bullet i_2(t_b) - L \bullet i_2(t_a)$$

$$\text{[EQ12]}$$

Or, $i_2(t_a) = 0$ donc l'équation peut s'ecrire [EQ12] sous la forme suivante:

$$\int\limits_{ta}^{tb}\left(U_{Rc2}(t)-U_{Rc1}(t)\right)dt = R \bullet \int\limits_{ta}^{tb}i_2(t)dt + L \bullet i_2(t_b) \qquad\qquad \text{[EQ12 bis]}$$

Notons que l'appareil permet justement de mesurer : $U_{RC1}(t)$, $U_{RC2}(t)$ ainsi que $i_2(t)$.

Nous appellerons maintenant:

$$U_{Charge}(t) = U_{Rc2}(t)\,, \quad U_{Vide}(t) = U_{Rc1}(t) \quad \text{et} \quad i_{Charge}(t) = i_2(t)\,.$$

d'où:

$$\int\limits_{ta}^{tb}\left(U_{Charge}(t)-U_{Vide}(t)\right)dt = R \bullet \int\limits_{ta}^{tb}i_{Charge}(t)dt + L \bullet i_{Charge}(tb) \quad \text{[EQ13]}$$

L'équation [EQ13] s'écrit alors :

$$\underline{\Delta U} = R \bullet \underline{I} + L \bullet \hat{I}_t \qquad\qquad \text{[EQ14]}$$

L'équation [EQ13] fait appel à deux intégrations et à une valeur instantanée :

○ Premiere intégration:

$$\underline{\Delta U} = \int\limits_{t1}^{t2}\left(U_{Charge}(t)-U_{Vide}(t)\right)dt$$

○ <u>Seconde Intégration :</u>

$$\underline{I} = \int\limits_{t1}^{t2}i_{Charge}(t)dt$$

○ <u>Valeur Instantanée:</u>

$$\hat{I}_t = L \bullet i_{Charge}(t)\,\text{avec}\;i_{Charge}(t)$$

La représentation physique de la mesure est la suivante : le signal $s\,(t)$ est représenté idéalement par la fonction $s\,(t) = S_{max}.sin\,(\omega.t)$ ; nous allons travailler par symétrie axiale et par symétrie centrale. En fonction des repères temporels choisis, la fonction est paire ou impaire.

Lorsque l'on applique des impulsions doubles dans des intervalles de temps indiqués sur la figure 3B, les signaux sont exprimés par les quatre intégrales suivantes :

$$S1 = \int_{t1}^{t2} s(t)dt \; ,$$

$$S2 = \int_{t3}^{t4} s(t)dt \; ,$$

$$S3 = \int_{t5}^{t6} s(t)dt \; ,$$

$$S1 = \int_{t7}^{t8} s(t)dt$$

[EQ15]

En utilisant la représentation angulaire du signal $s\,(t) = S_{max} \cdot sin\,(\omega \cdot t)$ , on a:

$\theta = \omega \cdot t$ et donc: $\theta_1 = \omega \cdot t_1$ ; $\theta_2 = \omega \cdot t_2$ ; $\theta_3 = \omega \cdot t_3$ ; $\theta_4 = \omega \cdot t_4$

Posons $\theta_2 = \theta_1 + \alpha$ et $\theta_4 = \theta_3 + \alpha$,
ainsi que

$$\theta_1 = \frac{\pi}{2} - \phi_1 \quad et \quad \theta_4 = \frac{\pi}{2} + \phi_1 \qquad [EQ16a] \; et \; [EQ16b]$$

où $\alpha = f(t_{n+1} - t_n)$ represente donc le temps d'intégration. Les équations [EQ16a] et [EQ16b] impliquent: $sin(\theta_1) = sin(\theta_4)$ et ce, quel que soit $\phi_1$. Par conséquent, au vu des relations qui lient respectivement $\theta_1$ et $\theta_4$ à $\theta_2$ et $\theta_3$, on peut en déduire:

$sin(\theta_2) = sin(\theta_3)$, quel que soit $\phi_1$.

Par extension, en reprenant les quatre équations [EQ15] et sachant que $s\,(t)$ est de la forme $s\,(t) = S_{max}.sin\,(\omega.t)$ , on peut dire que:

$$\int_{t1}^{t2} s(t)dt = \int_{t3}^{t4} s(t)dt$$

ainsi que

$$\int_{t5}^{t6} s(t)dt = \int_{t7}^{t8} s(t)dt \qquad [EQ16c]$$

Or, par construction, $|\theta_1|$ et $|\theta_2|$ sont respectivement égaux avec $|\theta_7|$ et $|\theta_8|$. Comme s (t) est une fonction sinusoïdale, on a:

$$\int_{t1}^{t2} s(t)dt = \left| \int_{t7}^{t8} s(t)dt \right| \quad ;$$

On peut donc élaborer la relation suivante :

$$\left|\int_{t1}^{t2} s(t)dt\right| = \left|\int_{t3}^{t4} s(t)dt\right| = \left|\int_{t5}^{t6} s(t)dt\right| = \left|\int_{t7}^{t8} s(t)dt\right|$$

Cette quadruple égalité est importante pour la réalisation de l'intégration du signal, cette dernière étant effectuée sur différents intervalles de temps étalés sur plusieurs périodes.

A présent l'intégration sera notée:

$$\left|\int_{t_n}^{t_{n+1}} s(t)dt\right|$$

**Mesure et calcul:** En termes de mesure et en reprenant l'équation [EQ14], nous pouvons physiquement mesurer les grandeurs suivantes : $\underline{\Delta U}$, $\underline{I}$ et $\hat{I}_t$ (équation à 2 inconnues: $R$ et $L$).

En réalisant deux mesures distinctes effectuées sur le même segment $t_n$ et $t_{n+1}$, nous obtenons un système à 2 équations et 2 inconnues

$$\text{Mesure 1:} \quad \underline{\Delta U_1} = R \bullet \underline{I_1} + L \bullet \hat{\underline{I}}_{t1}$$

$$\text{Mesure 2:} \quad \underline{\Delta U_2} = R \bullet \underline{I_2} + L \bullet \hat{\underline{I}}_{t2}$$

Pour des commodité de résolution, nous allons les noter comme suit:

$$R = -\frac{\hat{I}_{t1}}{\underline{I_1}} \bullet L + \frac{\underline{\Delta U_1}}{\underline{I_1}} \Leftrightarrow y = a_1 \bullet x + b_1$$

$$R = -\frac{\hat{I}_{t2}}{\underline{I_2}} \bullet L + \frac{\underline{\Delta U_2}}{\underline{I_2}} \Leftrightarrow y = a_2 \bullet x + b_2$$

Le système est à présent le suivant:

$$\begin{cases} y = a_1 \bullet x + b_1 \\ y = a_2 \bullet x + b_2 \end{cases} \qquad \text{[EQ17]}$$

Les solutions du système sont les suivantes:

$$x = \frac{b_2 - b_1}{a_1 - a_2} \qquad \text{et} \qquad y = \frac{a_2 \bullet b_1 - a_1 \bullet b_2}{a_2 - a_1}$$

ce qui donne finalement, après simplifications:

$$L = \frac{\Delta U_2 \bullet \hat{I}_1 - \Delta U_1 \bullet \hat{I}_2}{\hat{I}_{t2} \bullet \hat{I}_1 - \hat{I}_{t1} \bullet \hat{I}_2}$$

$$R = \frac{\hat{I}_{t1} \bullet \Delta U_2 - \hat{I}_{t2} \bullet \Delta U_1}{\hat{I}_{t1} \bullet \hat{I}_2 - \hat{I}_{t2} \bullet \hat{I}_1}$$

## Revendications

1. Procédé de détermination des composantes active et réactive de l'impédance de boucle d'un réseau d'alimentation en courant alternatif fournissant le courant sous une tension de réseau, par la mesure des tensions et courants de boucle, la boucle comprenant un conducteur de ligne du réseau et au moins un des deux conducteurs suivants :

   ■ un conducteur de neutre du réseau,
   ■ un conducteur de protection par mise à la terre,

   procédé **caractérisé en ce que** l'on applique une charge de test à la boucle, on mesure la tension de la boucle avant que la charge de test soit appliquée et lorsque la charge de test est appliquée, on mesure l'évolution temporelle du courant pendant la durée pendant laquelle la charge de test est appliquée et on détermine les parties active (résistance « R ») et réactive (inductance « L ») de l'impédance de boucle par analyse conjointe d'une part des résultats de mesures différentielles de tension de boucle et d'autre part de l'évolution temporelle du courant dans la charge de test.

2. Procédé selon la revendication 1, **caractérisé en ce que** l'on détermine les parties active (résistance « R ») et réactive de l'impédance de boucle en utilisant pour l'analyse conjointe les formules suivantes:

$$R = \frac{\hat{I}_{t1} \bullet \Delta U_2 - \hat{I}_{t2} \bullet \Delta U_1}{\hat{I}_{t1} \bullet \hat{I}_2 - \hat{I}_{t2} \bullet \hat{I}_1}$$

$$L = \frac{\Delta U_2 \bullet \hat{I}_1 - \Delta U_1 \bullet \hat{I}_2}{\hat{I}_{t2} \bullet \hat{I}_1 - \hat{I}_{t1} \bullet \hat{I}_2}$$

où :

$\hat{I}_{t1}$ représente la valeur instantanée « $I_{pic1}$ » du courant dans la charge de test à la fin de la durée « T1 »
$\hat{I}_{t2}$ représente la valeur instantanée « $I_{pic2}$ » du courant dans la charge de test à la fin de la durée « T2 »
$\Delta U_1$ représente la valeur intégrale de la différence de tension [« à vide » - « en charge »] pendant la durée « T1 »
$\Delta U_2$ représente la valeur intégrale de la différence de tension [« à vide » - « en charge »] pendant la durée « T2 »
$\hat{I}_1$ représente la valeur intégrale du courant dans la charge de test pendant la durée « T1 »
$\hat{I}_2$ représente la valeur intégrale du courant dans la charge de test pendant la durée « T2 »

3. Procédé selon la revendication 1 ou 2 **caractérisé en ce que** l'impulsion de courant est obtenue par une commande électronique d'application de la charge de test par un instrument de mesure effectuant les mesures différentielles de la tension de boucle et les mesures de l'évolution temporelle du courant.

4. Procédé selon l'une quelconque des revendications 1 à 3, **caractérisé en ce que** la charge de test est appliquée sur un sommet de la tension de réseau.

5. Procédé selon l'une quelconque des revendications 1 à 3, **caractérisé en ce que** la charge de test est appliquée proche d'un sommet de la tension de réseau.

6. Procédé selon l'une quelconque des revendications 1 à 5, **caractérisé en ce que** la charge de test est appliquée de manière répétée de façon que la mesure de tension et de l'évolution temporelle du courant puissent être effectués, cumulés, moyennés sur plusieurs impulsions.

7. Procédé selon l'une quelconque des revendications 1 à 6, **caractérisé en ce que** la charge de test est appliquée de manière répétée de façon que le courant puisse être mesuré sous la forme d'au moins deux impulsions par période de la tension de réseau.

8. Procédé selon la revendication 5 ou 6, **caractérisé en ce que**, d'une période de la tension de réseau à l'autre, la séquence d'une impulsion avant application de la charge et d'une impulsion après application de la charge est inversée.

9. Procédé selon l'une quelconque des revendications 5 à 8, **caractérisé en ce que** l'impédance est obtenue moyennant une intégration des résultats des mesures respectivement de la tension différentielle de boucle et du courant.

10. Dispositif de mesurage d'impédance de boucle, **caractérisé en ce qu'**il comprend un pont diviseur d'entrée (2) destiné à être raccordé à un réseau électrique (1) dans lequel l'impédance de boucle doit être mesuré, et respectivement pour la mesure d'une tension et la mesure d'un courant à partir desquels l'impédance de boucle doit être déterminée, au moins un intégrateur (51, 52, 53) relié au pont diviseur (2) par une mémoire tampon (3) et une commande marche/arrêt (4), ainsi que des moyens de mesure et de traitement (7) recevant des signaux issus du ou des intégrateurs (51, 52, 53) et comprenant des moyens de mise à disposition des résultats de mesure.

**Patentansprüche**

1. Verfahren zur Bestimmung der aktiven und reaktiven Schleifenimpedanzkomponenten eines Netzes zur Versorgung mit Wechselstrom, das den Strom in einer Netzspannung liefert, durch Messung der Spannungen und Stromstärken der Schleife, wobei die Schleife einen Linienleiter des Netzes und mindestens einen der zwei folgenden Leiter umfasst:

   - einen Neutralleiter des Netzes,
   - einen Schutzleiter durch Erdung,
   wobei das Verfahren **dadurch gekennzeichnet ist, dass** an die Schleife eine Testlast angelegt wird, die Spannung der Schleife vor Anlegen der Testlast gemessen wird und dass, wenn die Testlast anliegt, die zeitliche Entwicklung des Stroms während der Dauer gemessen wird, in der die Testlast angelegt ist, und der aktive (Widerstand "R") und reaktive (Induktivität "L") Teil der Schleifenimpedanz durch gemeinsame Analyse einerseits der Ergebnisse der Differentialmessungen der Schleifenspannung und andererseits der zeitlichen Entwicklung des Stroms in der Testlast bestimmt wird.

2. Verfahren nach Anspruch 1, **dadurch gekennzeichnet, dass** der aktive (Widerstand "R") und reaktive Teil der Schleifenimpedanz durch Verwendung für die gemeinsame Analyse der folgenden Formeln bestimmt wird:

$$R = \frac{\hat{I}_{t1} \bullet \Delta U_2 - \hat{I}_{t2} \bullet \Delta U_1}{\hat{I}_{t1} \bullet \underline{I}_2 - \hat{I}_{t2} \bullet \underline{I}_1}$$

$$L = \frac{\Delta U_2 \bullet \underline{I}_1 - \Delta U_1 \bullet \underline{I}_2}{\hat{I}_{t2} \bullet \underline{I}_1 - \hat{I}_{t1} \bullet \underline{I}_2}$$

wobei:

$\hat{I}_{t1}$ den Momentanwert "$I_{pic1}$" des Stroms in der Testlast am Ende der Dauer "T1" darstellt,
$\hat{I}_{t2}$ den Momentanwert "$I_{pic2}$" des Stroms in der Testlast am Ende der Dauer "T2" darstellt,
$\Delta U_1$ den Integralwert der Spannungsdifferenz ["leer" - "unter Last"] während der Dauer "T1" darstellt,
$\overline{\Delta U_2}$ den Integralwert der Spannungsdifferenz ["leer" - "unter Last"] während der Dauer "T2" darstellt,
$\underline{I_1}$ den Integralwert des Stroms in der Testlast während der Dauer "T1" darstellt,
$\underline{I_2}$ den Integralwert des Stroms in der Testlast während der Dauer "T2" darstellt.

3. Verfahren nach Anspruch 1 oder 2, **dadurch gekennzeichnet, dass** der Stromimpuls durch einen elektronischen Anwendungsbefehl der Testlast durch ein Messinstrument erzeugt wird, das die Differentialmessungen der Schleifenspannung und die Messungen der zeitlichen Entwicklung des Stroms durchführt.

4. Verfahren nach einem der Ansprüche 1 bis 3, **dadurch gekennzeichnet, dass** die Testlast auf eine Spitze der Netzspannung angewendet wird.

5. Verfahren nach einem der Ansprüche 1 bis 3, **dadurch gekennzeichnet, dass** die Testlast in der Nähe einer Spitze der Netzspannung angewendet wird.

6. Verfahren nach einem der Ansprüche 1 bis 5, **dadurch gekennzeichnet, dass** die Testlast wiederholt derart angewendet wird, dass die Messung der Spannung und der zeitlichen Entwicklung des Stroms kumuliert gemittelt über mehrere Impulse durchführbar ist.

7. Verfahren nach einem der Ansprüche 1 bis 6, **dadurch gekennzeichnet, dass** die Testlast wiederholt derart angewendet wird, dass der Strom in Form von mindestens zwei Impulsen je Netzspannungsperiode messbar ist.

8. Verfahren nach Anspruch 5 oder 6, **dadurch gekennzeichnet, dass** von einer Netzspannungsperiode zur anderen die Sequenz eines Impulses vor Anlegen der Last und eines Impulses nach Anlegen der Last umgekehrt wird.

9. Verfahren nach einem der Ansprüche 5 bis 8, **dadurch gekennzeichnet, dass** die Impedanz anhand einer Integration der Ergebnisse der jeweiligen Messungen der Differentialspannung der Schleife und des Stroms ermittelt wird.

10. Messvorrichtung der Schleifenimpedanz, **dadurch gekennzeichnet, dass** sie eine Teilungseingangsbrücke (2), die zum Anschluss an ein elektronisches Netz (1), in dem die Schleifenimpedanz gemessen werden muss, und jeweils für das Messen einer Spannung und das Messen eines Stroms, von denen ausgehend die Schleifenimpedanz bestimmt werden muss, bestimmt ist, mindestens einen Integrator (51, 52, 53), der mit der Teilungsbrücke (2) durch einen Pufferspeicher (3) verbunden ist, und eine Ein-/Aus-Steuerung (4) sowie Mess- und Verarbeitungsmittel (7) umfasst, die Signale von dem oder den Integratoren (51, 52, 53) erhalten und Mittel zur Bereitstellung der Messergebnisse umfassen.

## Claims

1. A method for determining active and reactive loop impedance components of an alternative current network supplying current under a network voltage, by measuring the loop voltages and currents, the loop comprising a line conductor of the network and at least one of the following two conductors:

   ■ a neutral conductor of the network,
   ■ a grounding protection conductor,
   said method being **characterized in that** a test charge is applied to the loop, the voltage of the loop is measured before the test charge is applied and when the test charge is applied, the evolution of the current over time is measured during the period during which the test charge is applied, and the active ("R" resistance) and reactive ("L" inductance) parts of the loop impedance are determined through joint analysis of the results of differential loop voltage measurements on the one hand and the evolution of the current in the test charge over time on the other hand.

2. The method according to claim 1, **characterized in that** the active ("R" resistance) and reactive parts of the loop impedance are determined using the following formulas for the joint analysis:

$$R = \frac{\hat{I}_{t1} \bullet \Delta U_2 - \hat{I}_{t2} \bullet \Delta U_1}{\hat{I}_{t1} \bullet I_2 - \hat{I}_{t2} \bullet I_1}$$

$$L = \frac{\Delta U_2 \bullet I_1 - \Delta U_1 \bullet I_2}{\hat{I}_{t2} \bullet I_1 - \hat{I}_{t1} \bullet I_2}$$

where:

$\hat{I}_{t1}$ represents the instantaneous value "$I_{pic1}$" of the current in the test charge at the end of period "T1,"

$\hat{I}_{t2}$ represents the instantaneous value "$I_{pic2}$" of the current in the test charge at the end of period "T2,"

$\Delta U_1$ represents the integral value of the ["no-load" - "on load"] voltage difference during the period "T1,"

$\overline{\Delta U_2}$ represents the integral value of the ["no-load" - "on load"] voltage difference during the period "T2,"

$\overline{I_1}$ represents the integral value of the current in the test charge during the period "T1,"

$\overline{I_2}$ represents the integral value of the current in the test charge during the period "T2."

3. The method according to claim 1 or 2, **characterized in that** the current pulse is obtained by an electronic command to apply the test charge using a measuring instrument performing the differential measurements of the loop voltage and the measurements of the evolution of the current over time.

4. The method according to any one of claims 1 to 3, **characterized in that** the test charge is applied on an apex of the network voltage.

5. The method according to any one of claims 1 to 3, **characterized in that** the test charge is applied near an apex of the network voltage.

6. The method according to any one of claims 1 to 5, **characterized in that** the test charge is applied repeatedly so that the measurement of the voltage and of the evolution of the current over time can be done, cumulatively, averaged over several pulses.

7. The method according to any one of claims 1 to 6, **characterized in that** the test charge is applied repeatedly so that the current can be measured in the form of at least two pulses per period of the network voltage.

8. The method according to claim 5 or 6, **characterized in that**, from one period of the network voltage to the next, the sequence of a pulse before application of the charge and a pulse after application of the charge is reversed.

9. The method according to any one of claims 5 to 8, **characterized in that** the impedance is obtained subject to integration of the results of the measurements of the differential loop voltage and the current, respectively.

10. A loop impedance measuring device, **characterized in that** it comprises an input divider bridge (2) designed to be connected to an electrical network (1) in which the loop impedance must be measured, and to measure a voltage and a current, respectively, from which the loop impedance must be determined, at least one integrator (51, 52, 53) connected to the divider bridge (2) by a buffer memory (3) and a start/stop command (4), as well as measuring and processing means (7) receiving signals from the integrator(s) (51, 52, 53) and comprising means for providing the measurement results.

**Fig. 1**

R    L

e(t)    U    $R_C$

**Fig. 2**

I

0,7

0,5

0,3

0,1

0    0,01    0,02    0,03    t/s

**Fig. 3A**

Période secteur    Période secteur

à vide    à vide

0°    90°    180°    270°    360°    90°    180°    270°    360°

en charge    en charge

**Fig. 3B**

S1    S2

t5 t6 t7 t8

t1 t2 t3 t4    S3    S4

_Fig. 4_

Période secteur

Période secteur

à vide

en charge

0°   90°   180°   270°   360°   90°   180°   270°   360°

en charge

à vide

mini-cycle impair

mini cycle pair

en charge

en charge   à vide

90°   180°   270°   360°   450°

a vide   à vide

_Fig. 5_

_Fig. 6_

_Fig. 7_

I

Ipic 2

ΔI   Ipic 1

_Fig. 8_

T1   T2   t

T3

Fig. 9

**Fig. 10**

**EP 1 774 347 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 0881500 A